# EUROPEAN PATENT SPECIFICATION

(11) **EP 0 314 808 B1**
(45) Date of publication and mention of the grant of the patent: **28.04.1993**
(21) Application number: 88904265.1
(22) Date of filing: 13.05.1988
(51) Int. Cl.: H02M 7/5387, H03K 17/16

(54) **CLIPPER CIRCUIT FOR POWER TRANSISTOR CIRCUIT AND INVERTER CIRCUIT UTILIZING THE SAME**
SPANNUNGSBEGRENZUNGSSCHALTUNG FÜR LEISTUNGSTRANSISTOR UND WECHSELRICHTER
CIRCUIT ECRETEUR POUR CIRCUIT TRANSISTORISE DE PUISSANCE ET CIRCUIT INVERSEUR L'UTILISANT

(30) Priority: 13.05.1987 JP 71248/87 U
(43) Date of publication of application: 10.05.1989
(73) Proprietor: OTIS ELEVATOR COMPANY, Farmington, CT 06032 (US)
(72) Inventor: IWASA, Masao, Chiba-shi Chiba-ken 281 (JP); KITO, Yasutami, Nishikasugai-gun Aichi-ken 452 (JP)
(74) Representative: Tomlinson, Kerry John
(86) International application number: JP8800458
(87) International publication number: WO8809085

(56) References cited:
- DE-A- 2 644 715
- DE-A- 2 724 741
- DE-A- 3 527 675
- PATENT ABSTRACTS OF JAPAN, volume 7, no. 247 (E-208)(1392), 2 November 1983, & JP, A, 58133184 (MATSUSHITA DENKO K.K.) 8 August 1983
- PATENT ABSTRACTS OF JAPAN, volume 11, no. 4 (E-468)(2451), 7 January 1987, & JP, A, 61180576 (HITACHI LTD) 13 August 1986

## Description

The present invention relates generally to a clipper circuit for a power transistor for absorbing surge voltage. More specifically, the invention relates to a clipper circuit which is suitable for simplification of a power transistor circuit and thereby allowing the power transistor circuit to be made satisfactorily compact.

Power transistor circuits have been used in various electric source units as large current control elements. For example, a power transistor may be employed as a switching element in an inverter circuit. In such cases, it is a known technique to provide a clipper circuit in the power transistor circuit for absorbing surge voltages which are generated upon shutting off the current, and thereby protecting the power transistor.

The conventional power transistor circuit, which is employed in a single phase inverter circuit, is associated with a power source clipper circuit interposed between the power transistor circuit and a power source. The power source clipper circuit is designed to absorb surge voltage generated in the power source. The power transistor circuit also incorporates a clipper circuit. The clipper circuit in the power transistor circuit cooperates with the power source clipper circuit at the time of current shut off so that surges having high dv/dt are absorbed by the clipper circuit in the power transistor circuit and large energy surges are absorbed by the power source clipper circuit.

DE 2644715 discloses a one-way electronic switch which prevents high power loss when a power transistor is switched ON and can withstand greater reverse voltages when the power transistor is switched OFF. An inductor is connected into every current carrying path when the transistor is switched ON to limit the rate of increase of current through the switch. A capacitor/diode circuit is connected across the collector-emitter of the transistor with the polarity of the diode chosen to prevent current flowing in the reverse direction.

In general, the clipper circuit incorporated in the power transistor circuit is a series circuit comprised of a capacitor and a diode, and a discharge resistor. The capacitor-diode circuit is connected in parallel to a collector-emitter circuit of a power transistor. When the power transistor is turned OFF, collector current flows through the capacitor-diode series circuit. In the transistion, the current is divided by the capacitor and the diode. By dividing the current, voltage surges due to inductance of the wiring and so forth can be absorbed to lower the dv/dt of voltage variations in the collector-emitter circuit of the power transistor. However, in the vicinity of the zero-crossing of the divided current, high frequency oscillation tends to be caused. This high frequency oscillation causes turning ON of the power transistor which, in turn causes shorting breakage upon turn ON of the other power transistor circuit. In order to suppress the voltage oscillation, a snubber circuit is provided in the power transistor circuit.

### SUMMARY OF THE INVENTION

The present invention is intended to reduce the number of circuit components used in constructing a power transistor circuit and thus allow the power transistor circuit to be made satisfactorily compact.

Therefore, it is an object of the present invention to provide a power transistor circuit including an improved clipper circuit which eliminates the necessity of a snubber circuit.

Another object of the invention is to provide a power transistor circuit which is applicable for an inverter circuit and allows the omission of a power source clipper circuit.

In order to accomplish the aforementioned and other objects, a clipper circuit, according to the present invention, includes an auxiliary diode connected between a capacitor and diode forming a clipper circuit. The auxiliary diode thus forms an auxiliary clipper circuit taking the capacitor as a common capacitor. The auxiliary clipper circuit shunts current through the capacitor into a first and second current flowing through the diodes. This avoids the necessity of a snubber circuit and of a power source clipper circuit as employed in the power transistor circuit of an inverter circuit.

According to one aspect of the invention, there is provided a clipper circuit for a power transistor circuit including a power transistor comprising:
a first clipper circuit, adapted to absorb high dv/dt surge voltage connected in parallel to a collector-emitter circuit of said power transistor and including a capacitor and a first diode; and
a second clipper circuit, adapted to absorb a surge energy generated by wiring inductance, upon turning OFF of said power transistor, including a second diode connected to said capacitor and connected in parallel to a discharge resistor wherein said second diode of said second clipper circuit is connected to a junction between said capacitor and said first diode so that current flowing through said capacitor is shunted into a first shunted current flowing through said first diode and second shunted current flowing through said second diode; characterized in that
said first and second clipper circuits are active for reducing said first and second shunted currents flowing through said first and second diodes according to increasing voltage in said capacitor, and said second clipper circuit has greater inductance, in series with the second diode, than said first clipper circuit such that said first and second clipper circuits cause said first and second shunted current to be decreased to zero at mutually different timings in that said second clipper circuit maintains said second shunted current after termination of said first shunted current flowing through said first diode.

According to another aspect of the invention, there is provided a power transistor circuit comprising:
a power transistor connected to a power source and switching between a first state for establishing a collector-emitter circuit and a second state for blocking said collector-emitter circuit for supplying drive power to a load connected thereto; and
a clipper circuit for absorbing surge energy to be generated upon switching of said power transistor from said first state to said second state, said clipper circuit including
a first clipper circuit connected in parallel to said collector-emitter circuit of said power transistor and including a capacitor and a first diode; and
a second clipper circuit including a second diode connected to said capacitor in parallel to a discharge resistor;
wherein said first clipper circuit is adapted to absorb high dv/dt surge voltage and said second clipper circuit is adapted to absorb surge energy generated by wiring inductance, upon switching of said power transistor from said first state to said second state, and
wherein said second diode of said second clipper circuit is connected to a junction between said capacitor and said first diode so that current flowing through said capacitor is shunted into a first shunted current flowing through said first diode and a second shunted current flowing through said second diode; characterized in that said first and second clipper circuits are active for reducing said first and second shunted currents through said first and second diodes according to the increase of charge voltage in said capacitor and said second clipper circuit is provided with greater inductance in series with the second diode than said first clipper circuit such that said first and second clipper circuits cause said first and second shunted current to decrease to zero at mutually different times in that said second clipper circuit maintains said second shunted current after termination of said first shunted current flowing through said first diode.

According to a further aspect of the invention, there is provided an inverter circuit connected to a direct current source via a smoothing circuit including a smoothing capacitor, comprising:
a plurality of power transistor circuits connected to a load for supplying an alternating current to the latter, each of said power transistor circuits including a power transistor switching between a first state for establishing a collector-emitter circuit and a second state for blocking said collector-emitter circuit; and
a clipper circuit for absorbing surge energy generated upon switching of said power transistor from said first state to said second state, said clipper circuit including a first clipper circuit, adapted to absorb high dv/dt surge voltage connected in parallel to said collector-emitter circuit of said power transistor and comprising a capacitor and a first diode, and a second clipper circuit adapted to absorb surge energy generated by wiring inductance, upon switching of said power transistor from said first state to said second state including a second diode connected to said capacitor in parallel to a discharge resistor, wherein said second diode of said second clipper circuit is connected to a junction between said capacitor and said first diode so that current flowing through said capacitor is shunted into a first shunted current flowing through said first diode and a second shunted current flowing through said second diode; characterized in that
said first and second clipper circuits are active for reducing said first and second shunted currents flowing through said first and second diodes according to increasing voltage in said capacitor, and said second clipper circuit is provided with greater inductance in series with the second diode than said first clipper circuit, such that said first and second clipper circuits cause said first and second shunted currents to be decreased to zero at mutually different times in that said second clipper circuit maintains said second shunted current after termination of said first shunted current flowing through said first doide.

It is also preferable that the power transistor circuit further comprises an auxiliary capacitor connected in parallel to the first diode. The auxiliary capacitor has smaller capacitance than the capacitor in the clipper circuits.

In the mechanical construction, the first and second clipper circuits are mounted on a printed circuit board connected to the collector and emitter electrode terminals of the power transistor formed on a substrate via a connecting screw, the printed circuit board is placed in spaced apart relationship with the opposing surface of the substrate. Such construction of circuit assembly effectively reduces wiring inductance and provides better surge absorption characteristics.

### BRIEF DESCRIPTION OF THE DRAWINGS

The present invention will be understood more fully from the detailed description given herebelow and from the accompanying drawings of the preferred embodiment of the invention, which, however, should not be taken to limit the invention to the specific embodiment but are for explanation and understanding only.

In the drawings:
**Fig. 1** is a circuit diagram of a single phase inverter circuit which employs power transistor circuits, each incorporating the preferred embodiment of a clipper circuit according to the present invention;
**Fig. 2** shows waveforms at various sections in the inverter circuit of **Fig. 1**;
**Fig. 3** is a plan view of the preferred construction of an assembly of the power transistor circuit;
**Fig. 4** is a front elevation of the power transistor circuit assembly of **Fig. 3**; and
Fig. 5 is a front elevation of another embodiment of the construction of the power transistor circuit assembly according to the invention.

### DESCRIPTION OF THE PREFERRED EMBODIMENT

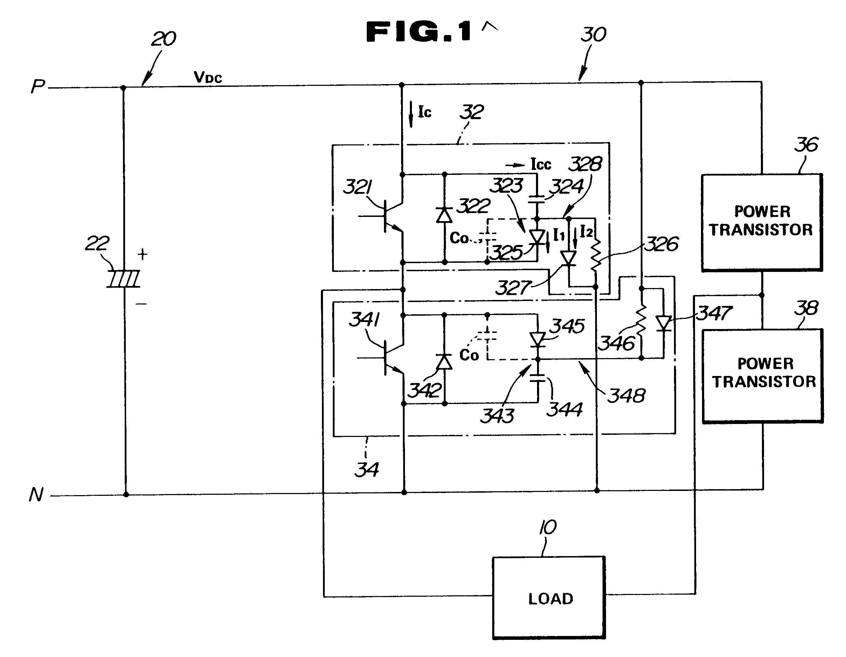

Referring now to the drawings, particularly to **Fig. 1**, there is depicted a known main or power circuit of a single phase inverter circuit, which is connected to a load **10**, such as an induction motor. The inverter main circuit is connected to a known converter circuit (not shown) to receive direct current power supply therefrom. The inverter main circuit generally comprises a smoothing stage **20** including a smoothing capacitor **22** for smoothing, and an inverter stage which is generally represented by the reference numeral **30**. As is well known, the smoothing stage **20** is interposed between the converter and the inverter stage **30**, i.e. the inverter main circuit, for absorbing ripples in the direct power supplied from the converter.

The inverter stage **30** includes pairs of the power transistor circuits **32**, **34** and **36**, **38**, of the preferred embodiments. These pairs of power transistor circuits **32**, **34** and **36**, **38** are connected to the load 10 for driving the latter. On the other hand, the power transistor circuits 32, 34 and 36, 38 are connected to a known switching signal generator circuit in an inverter control circuit. Thus, the switching timing is controlled so as to generate a single-phase alternating current to supply to the load 10, in a well known manner.

It should be noted that the power transistor circuits **36** and **38** are identical in construction to the power transistor circuits 32 and 34. Therefore, detailed construction of these power transistor circuits **36** and **38** is not shown in **Fig. 1**.

The power transistor circuit **32** includes a power transistor **321** connected to the switching signal generator of the control circuit at the base electrode. The collector electrode of the power transistor **321** receives the power source current Ic from the converter. A flywheel diode **322** is connected in parallel to the collector-emitter circuit of the power transistor **321**. A first clipper circuit **323** comprising a capacitor **324** and a first diode **325**, is also provided in parallel to the the collector-emitter circuit of the power transistor **321**. A junction between the capacitor **324** and the first diode **325**, is connected to the negative terminal of the converter via a discharge resistor **326**. A second diode **327** is also connected to the junction between the capacitor **324** and the first diode **325** in parallel to the discharge resistor **326**. The second diode **327** thus forms a second clipper circuit **328** with the capacitor **324**.

In the preferred construction, the second diode **327** of the second clipper circuit **328** is so designed and arranged as to provide the second clipper circuit 328 with a much greater inductance (L) than that of the first clipper circuit **323**.

Similarly to the power transistor circuit **32**, the power transistor circuit 34 includes a power transistor **341** connected to the switching signal generator of the control circuit at the base electrode. The collector electrode of the power transistor **341** is connected to the emitter electrode of the power transistor **321** to form a series circuit comprised of the power transistors **321** and **341**. The emitter electrode of the power transistor **341** is connected to the negative terminal of the converter. A junction between the power transistors **321** and **341** is connected to the load **10**.

In parallel to the collector-emitter circuit of the power transistor **341**, a flywheel diode **342** is connected. A first clipper circuit **343** comprising a capacitor **344** and a first diode **345**, is also provided in parallel to the the collector-emitter circuit of the power transistor **341**. The junction between the capacitor **344** and the first diode **345**, is connected to the positive terminal of the converter via a discharge resistor **346**. A second diode **347** is also connected to the junction between the capacitor **344** and the first diode **345** in parallel to the discharge register **346**. The second diode **347** thus forms a second clipper circuit **348** with the capacitor **344**.

The second diode **347** of the second clipper circuit **348** is so designed and connected as to provide much greater inductance (L) for the second clipper circuit **348** than that of the first clipper circuit **343**.

The second clipper circuits 328 and 348 perform an equivalent function to the power source clipper circuit in the conventional inverter main circuit for absorbing surge voltage generated in the converter used as the DC power source, upon shutting OFF of the power supply. These second clipper circuits **328** and **348** are also cooperative with the first clipper circuits **323** and **343** to suppress voltage fluctuations caused in the OFF-**ON** transistions of respectively associated power transistors **321** and **341**.

Absorption of the voltage fluctuation in the first and second clipper circuits 323 and 328 of the power transistor circuit 32 will be discussed herebelow.

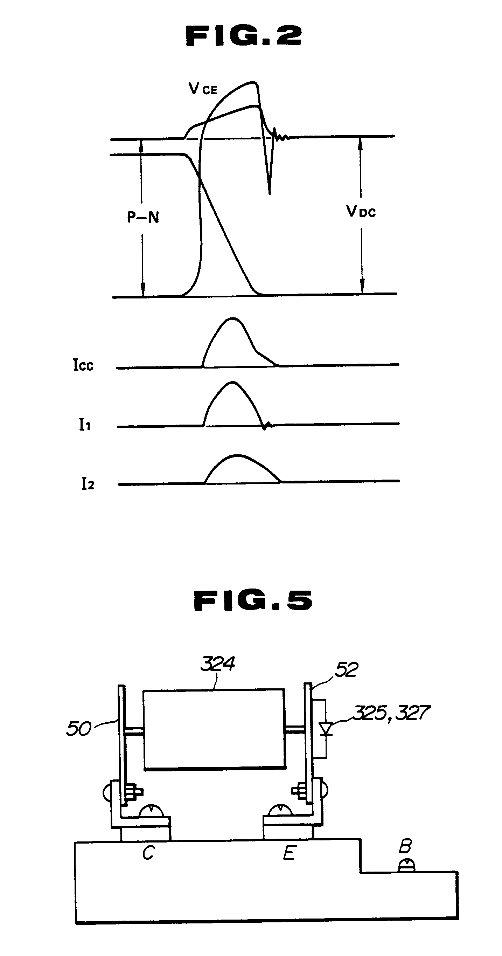

As shown in Fig. 2 when the power transistor 321 is turned OFF, load current Ic at the collector electrode of the power transistor **321** commutates to flow through the capacitor **324** as shunted current Icc. The current through the capacitor 324 is further shunted to flow through the diodes 325 and 327 as shunted currents I₁ and I₂. In this manner, the capacitor 324 is charged. The collector-emitter voltage V_{CE} *o*f the power transistor 321 is raised according to the increase of the capacitor voltage.

The smoothing capacitor 22 then serves to absorb surge energy for suppressing fluctuation of the power source voltage V_{DC}.

According to the increase of the capacitor voltage by charging the capacitor 324, the shunted currents I₁ and I₂ flowing through the diodes 325 and 327 drop proportionally to zero. In the embodiment shown, the first and second clipper circuits 323 and 328 are so constructed as to maintain the shunted current I₂ flowing through the diode 327 even after the shunted current I₁ of the diode 325 becomes zero, as shown in Fig. 2. By this, voltage fluctuation applied to the collector-emitter circuit of the power transistor 321 by reason of the recovery of the diode 325 upon a drop to zero of the shunted current I₁ flowing therethrough, can be held to a substantially small magnitude. The magnitude of voltage fluctuation on termination of the shunted current I₁ is thereby sufficiently reduced to make a snubber circuit which is required in the conventional circuit, unnecessary.

Upon termination of the shunted current I₂, recovery of the diode 327 causes voltage fluctuation due to inductance and capacitance in the whole circuit of the inverter main circuit. However, since the second clipper circuit 328 is so designed as to have much greater inductance than that of the first clipper circuit, the frequency of the voltage fluctuation can be kept low. Furthermore, backward resistance of the diode 327 aids suppression of the voltage fluctuation. Therefore, even upon recovery of the diode 327, high frequency voltage fluctuation which tends to cause breakdown of the power transistor 321 can be successfully suppressed.

It should be noted that the voltage fluctuation suppressive operation to be performed by the power transistor circuit 34 is substantially the same as that of the power transistor circuit 32 as set forth above. Therefore, detailed discussion about the circuit operation of the power transistor circuit 34 is omitted in order to simplify the disclosure and to avoid unnecessary repetition.

In the circuit construction shown in Fig. 1 and disclosed hereabove, it is further preferable to provide a capacitor C₀ which has substantially smaller capacitance than that of the diode 324 and 344. The capacitance of the capacitor C₀ can be one tenth of the capacitance of the capacitor 324, 344, for example. The capacitor C₀ may be effective for surpressing large magnitude surge voltages which can be caused upon termination of the shunt current flowing through the diodes 325 and 327.

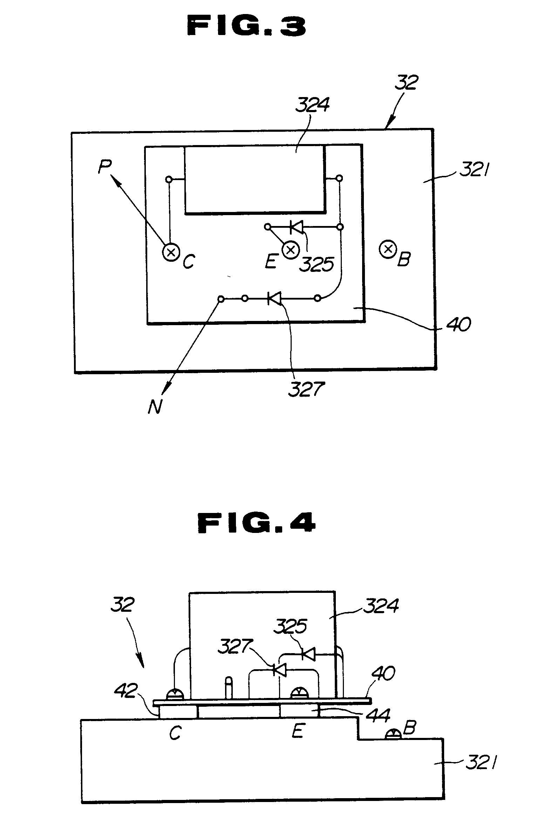

**Figs. 3** and **4** show the preferred construction of the power transistor circuit **32**. The power transistor **321** has a collector electrode terminal C and an emitter electrode terminal E. To these collector electrode terminal C and the emitter electrode terminal E, a printed circuit board **40** is secured by conductive screws. The printed circuit board **40** is oriented in a spaced apart relationship to the opposing surface of the power transistor **321** by means of spacers **42** and **44**. The capacitor **324**, the diodes **325** and **327**, the discharge resistor 326 (not shown) and so forth are rigidly secured on the surface of the printed circuit board 40 with electric connections made by printed wiring on the circuit board.

The shown constuction of the power transistor circuit **32** is effective for reducing wiring inductance between the collector and emitter electrode terminals C and E and the clipper circuits **323** and **328** so as to effectively absorb surge voltage.

**Fig. 5** shows another example of preferred construction of the transistor circuit **32**. In this embodiment, pair of printed circuit boards **50** and **52** are secured to the collector and the emitter electrode terminals C and E by means of conductive screws. The printed circuit boards **50** and **52** are arranged essentially perpendicular to the upper surface of the power transistor **321** and in parallel to each other. The pair of printed circuit boards 50 and 52 support therebetween the capacitor **324**. Other circuit elements, such as the diodes **325** and **327**, the discharge resistor 326 (not shown) and so forth are mounted on one of the printed circuit boards **50** and **52**.

The circuit construction illustrated in Fig. 5 is also effective for reducing the amount of wiring inductance and effectively absorbing the surge voltage.

Therefore, the invention fulfills all of the objects and advantages sought therefor.

While the present invention has been disclosed in terms of the preferred embodiment in order to facilitate better understanding of the invention, it should be appreciated that the invention can be embodied in various ways without departing from the principle of the invention. Therefore, the invention should be understood to include all possible embodiments and modifications to the shown embodiments which can be embodied without departing from the principle of the invention set out in the appended claims.

## Claims

1. A clipper circuit for a power transistor circuit (32,34,36,38) including a power transistor (321,341) comprising:
a first clipper circuit, adapted to absorb high dv/dt surge voltage,connected in parallel to a collector-emitter circuit of said power transistor (321,341) and including a capacitor (324,344) and a first diode (325,345); and
a second clipper circuit, adapted to absorb a surge energy generated by wiring inductance, upon turning OFF of said power transistor (321,341), including a second diode (327,347) connected to said capacitor (324,344) and connected in parallel to a discharge resistor (326,346), wherein said second diode (327,347) of said second clipper circuit is connected to a junction between said capacitor (324,344) and said first diode (325,345) so that current flowing through said capacitor (324,344) is shunted into a first shunted current (I₁) flowing through said first diode (325,345) and second shunted current (I₂)flowing through said second diode, characterized in that said first and second clipper circuits are active for reducing said first and second shunted currents (I₁,I₂) flowing through said first and second diodes according to increasing voltage in said capacitor (324,344), and said second clipper circuit has greater inductance, in series with the second diode than said first clipper circuit (327,347) such that said first and second clipper circuits cause said first and second shunted current to be decreased to zero at mutually different timings in that said second clipper circuit maintains said second shunted current (I₂) after termination of said first shunted current (I₁) flowing through said first diode (325,345).

2. A power transistor circuit comprising:
a power transistor (321,341) connected to a power source and switching between a first state for establishing a collector-emitter circuit and a second state for blocking said collector-emitter circuit for supplying drive power to a load (10) connected thereto; and
a clipper circuit for absorging surge energy to be generated upon switching of said power transistor (321,341) from said first state to said second state, said clipper circuit including:
a first clipper circuit connected in parallel to said collector-emitter circuit of said power transistor (321,341) and including a capacitor (324,344) and a first diode (325,345); and
a second clipper circuit including a second diode (327,347) connected to said capacitor (324,344) in parallel to a discharge resistor (326,346);
wherein said first clipper circuit is adapted to absorb high dv/dt surge voltage and said second clipper circuit is adapted to absorb surge energy generated by wiring inductance, upon switching of said power transistor (321,341) from said first state to said second state, and wherein said second diode (327,347) of said second clipper circuit is connected to a junction between said capacitor (324,344) and said first diode (325,345) so that current (I_{cc}) flowing through said capacitor (324,344) is shunted into a first shunted current (I₁) flowing though said first diode (325,345) and second shunted current (I₂) flowing through said second diode (327,347), characterized in that said first and second clipper circuits are active for reducing said first and second shunted currents (I₁,I₂) through said first and second diodes according to the increase of charge voltage in said capacitor (324,344), and said second clipper circuit is provided with greater inductance, in series with the second diode (327,347), than said first clipper circuit such that said first and second clipper circuits cause said first and second shunted current to decrease to zero at mutually different times in that said second clipper circuit maintains said second shunted current (I₂) after termination of said first shunted current (I₁) flowing through said first diode (325,345).

3. A power transistor circuit as set forth in claim 2, which further comprises an auxiliary capacitor (Co) connected in parallel to said first diode (325,345).

4. A power transistor circuit as set forth in claim 3, wherein said auxiliary capacitor (Co) has smaller capacitance than said capacitor (324,344) in said first clipper circuit.

5. A power transistor circuit as set forth in any of claims 2 to 4, wherein said first and second clipper circuits are mounted on a printed circuit board (40) connected to collector and emitter electrode terminal of said power transistor (321,341) formed on a substrate via connecting screws, and wherein said printed circuit board (40) is placed in spaced apart relationship with opposing surface of said substrate.

6. An inverter circuit connected to a direct current source via a smoothing circuit (20) including a smoothing capacitor (22), comprising:
a plurality of power transistor circuits (32,34,36,38) connected to a load (10) for supplying an alternating current to the latter, each of said power transistor circuits (32,34,36,38) including a power transistor (321,341) switching between a first state for establishing a collector-emitter circuit and a second state for blocking said collector-emitter circuit; and
a clipper circuit for absorbing surge energy generated upon switching of said power transistor (321,341) from said first state to said second state, said clipper circuit including a first clipper circuit, adapted to absorb high dv/dt surge voltage connected in parallel to said collector-emitter circuit of said power transistor (321,341) and comprising a capacitor (324,344) and a first diode (325,345), and a second clipper circuit adapted to absorb surge energy generated by wiring inductance, upon switching of said power transistor from said first state to said second state including a second diode (327,347) connected to said capacitor in parallel to a discharge resistor (326,346), wherein said second diode (327,347) of said second clipper circuit is connected to a junction between said capacitor (324,344) and said first diode (325,345) so that current flowing through said capacitor (324,344) is shunted into a first shunted current (I₁) flowing through said first diode (325,345) and a second shunted current (I₂) flowing through said second diode (327,347) characterized in that said first and second clipper circuits are active for reducing said first and second shunted currents flowing through said first and second diodes according to increasing voltage in said capacitor (324,344), and said second clipper circuit is provided with greater inductance, in series with the second diode (327,347), than said first clipper circuit, such that said first and second clipper circuits cause said first and second shunted currents to be decreased to zero at mutually different times in that said second clipper circuit maintains said second shunted current (I₂) after termination of said first shunted current (I₁) flowing through said first diode (325,345).

## Patentansprüche

1. Begrenzerschaltung für eine Leistungstransistorschaltung (32, 34, 36, 38), die einen Leistungstransistor (321, 341) enthält, umfassend:
eine erste Begrenzerschaltung, die dazu ausgebildet ist, Stoßspannungen mit hohem dv/dt zu absorbieren, die parallel zu einer Kollektor-Emitter-Strecke des Leistungstransistors (321, 341) geschaltet ist und die einen Kondensator (324, 344) und eine erste Diode (325, 345) enthält; und
eine zweite Begrenzerschaltung, die dazu ausgelegt ist, Stoßenergie zu absorbieren, die durch Verdrahtungsinduktivität bei Ausschalten des Leistungstransistors (323, 341) erzeugt wird, die eine zweite Diode (327, 347), welche an den Kondensator (324, 344) angeschlossen ist und parallel zu einem Entladungswiderstand (326, 346) geschaltet ist, enthält, wobei die zweite Diode (327, 347) der zweiten Begrenzerschaltung an einem Verbindungspunkt zwischen dem Kondensator (324, 344) und der ersten Diode (325, 345) geschaltet ist, so daß ein durch den Kondensator (324, 344) fließender Strom aufgeteilt wird in einen ersten Nebenschlußstrom (I₁), der durch die erste Diode (325, 345) fließt, und einen zweiten Nebenschlußstrom (I₂) der durch die zweite Diode fließt, dadurch gekennzeichnet, daß die erste und die zweite Begrenzerschaltung aktiv sind, um den ersten und den zweiten Nebenschlußstrom (I₁, I₂) die durch die erste und die zweite Diode fließen, entsprechend der ansteigenden Spannung in dem Kondensator (324, 344) zu reduzieren, wobei die zweite Begrenzerschaltung in Serie mit der zweiten Diode eine größere Induktivität besitzt als die erste Begrenzerschaltung (327, 347), so daß die erste und die zweite Begrenzerschaltung veranlassen, daß der erste und der zweite Nebenschlußstrom zu voneinander verschiedenen Zeitpunkten auf null abnehmen, indem die zweite Begrenzerschaltung den zweiten Nebenschlußstrom (I₂) nach Beendigung des durch die erste Diode (325, 345) fließenden ersten Nebenschlußstroms (I₁) aufrechterhält.

2. Leistungstransistorschaltung, umfassend:
einen Leistungstransistor (321, 341), der an eine Energieversorgung angeschlossen ist und umschaltet zwischen einem ersten Zustand, in welchem eine Kollektor-Emitter-Strecke gebildet wird, und einem zweiten Zustand in welchem die Kollektor-Emitter-Strecke blockiert wird, um einer daran angeschlossenen Last (10) Treiberleistung zuzuführen; und
eine Begrenzerschaltung zum Absorbieren von Stoßenergie, die beim Schalten des Leistungstransistors (321, 341) von dem ersten Zustand in den zweiten Zustand erzeugt wird, wobei die Begrenzerschaltung aufweist:
eine erste Begrenzerschaltung, die parallel zu der Kollektor-Emitter-Strecke des Leistungstransistors (321, 341) geschaltet ist und einen Kondensator (324, 344) sowie eine erste Diode (325, 345) enthält; und
eine zweite Begrenzerschaltung, die eine zweite Diode (327, 347) enthält, die an den Kondensator (324, 344) parallel zu einem Entladungswiderstand (326, 346) geschaltet ist;
wobei die erste Begrenzerschaltung dazu ausgebildet ist, eine Stoßspannung mit hohem dv/dt zu absorbieren, und die zweite Begrenzerschaltung dazu ausgebildet ist, durch Verdrahtungsinduktivität beim Schalten des Leistungstransistors (321, 341) aus dem ersten in den zweiten Zustand erzeugten Stoßenergie zu absorbieren, wobei die zweite Diode (327, 347) der zweiten Begrenzerschaltung angeschlossen ist an einen Verbindungspunkt zwischen dem Kondensator (324, 344) und der ersten Diode (325, 345), so daß der durch den Kondensator (325, 345) fließende Strom (I_{cc}) aufgeteilt wird in einen ersten Nebenschlußstrom (I₁), der durch die erste Diode (325, 345) fließt, und einem zweiten Nebenschlußstrom (I₂), der durch die zweite Diode (327, 347) fließt, dadurch gekennzeichnet, daß die erste und die zweite Begrenzerschaltung aktiv sind, um den ersten und den zweiten Nebenschlußstrom (I₁, I₂) durch die erste und die zweite Diode entsprechend der Zunahme der Ladespannung in dem Kondensator (324, 344) zu reduzieren, und die zweite Begrenzerschaltung in Serie mit der zweiten Diode eine größere Induktivität aufweist als die erste Begrenzerschaltung, so daß die erste und die zweite Begrenzerschaltung bewirken, daß der erste und der zweite Nebenschlußstrom zu voneinander verschiedenen Zeiten auf null abnehmen, indem die zweite Begrenzerschaltung den zweiten Nebenschlußstrom (I₂) aufrechterhält nach Beendigung des durch die erste Diode (3245, 345) fließenden ersten Nebenschlußstroms (I₁).

3. Leistungstransistorschaltung nach Anspruch 2, gekennzeichnet durch einen Hilfskondensator (Co), der parallel zu der ersten Diode (325, 345) geschaltet ist.

4. Leistungstransistorschaltung nach Anspruch 3, bei der der Hilfskondensator (Co) eine kleinere Kapazität besitzt als der Kondensator (324, 344) in der ersten Begrenzerschaltung.

5. Leistungstransistorschaltung nach irgendeinem der Ansprüche 2 bis 4, bei der die erste und die zweite Begrenzerschaltung auf einer gedruckten Schaltungsplatine (40) gelagert sind, welche über Verbindungsschrauben mit dem Kollektor- und dem Emitter-Elektrodenanschluß des auf einem Substrat ausgebildeten Leistungstransistors (321, 341) verbunden sind, wobei die gedruckte Schaltungsplatine (40) mit Abstand von der gegenüberliegenden Fläche des Substrats angeordnet ist.

6. Wechselrichterschaltung, die über eine mit einem Glättungskondensator (22) versehene Glättungsschaltung (20) an eine Gleichstromquelle angeschlossen ist, umfassend:
mehrere Leistungstransistorschaltungen (32, 34, 36, 38), die an eine Last (10) angeschlossen sind, um dieser einen Wechselstrom zuzuführen, wobei jede der Leistungstransistorschaltungen (32, 34, 36, 38) einen Leistungstransistor (321, 341) enthält, der umschaltet zwischen einem ersten Zustand zur Schaffung einer Kollektor-Emitter-Strecke und einem zweiten Zustand zum Sperren der Kollektor-Emitter-Strecke; und
eine Begrenzerschaltung zum Absorbieren von Stoßenergie, die beim Schalten des Leistungstransistors (321, 341) aus dem ersten in den zweiten Zustand erzeugt wird, wobei die Begrenzerschaltung eine erste Begrenzerschaltung enthält, die dazu ausgebildet ist, eine Stoßspannung mit hohem dv/dt zu absorbieren, die parallel zu der Kollektor-Emitter-Strecke des Leistungstransistors (321, 341) geschaltet ist, und die einen Kondensator (324, 344) und eine erste Diode (325, 345) aufweist, eine zweite Begrenzerschaltung, die dazu ausgebildet ist, Stoßenergie zu absorbieren, die beim Schalten des Leistungstransistors aus dem ersten in den zweiten Zustand durch Verdrahtungsinduktivität erzeugt wird, die eine zweite Diode (327, 347) enthält, die an den Kondensator parallel zu einem Entladungswiderstand (326, 346) angeschlossen ist, wobei die zweite Diode (327, 347) der zweiten Begrenzerschaltung angeschlossen ist an einen Verbindungspunkt zwischen dem Kondensator (324, 344) und der ersten Diode (325, 345) so daß ein durch den Kondensator (324, 344) fließender Strom aufgeteilt wird in einen ersten Nebenschlußstrom (I₁), der durch die erste Diode (325, 345) fließt, und einen zweiten Nebenschlußstrom (I₂), der durch die zweite Diode (327, 347) fließt, dadurch gekennzeichnet, daß die erste und die zweite Begrenzerschaltung aktiv sind, um den durch die erste und die zweite Diode fließenden ersten und zweiten Nebenschlußstrom entsprechend einer Zunahme der Spannung in dem Kondensator (324, 344) zu reduzieren, und die zweite Begrenzerschaltung in Serie mit der zweiten Diode (327, 347) mit einer größeren Induktivität versehen ist als die erste Begrenzerschaltung, so daß die erste und die zweite Begrenzerschaltung bewirken, daß der erste und der zweite Nebenschlußstrom zu voneinander verschiedenen Seiten auf null verringert sind, indem die zweite Begrenzerschaltung den zweiten Nebenschlußstrom (I₂) aufrechterhält nach Beendigung des ersten durch die erste Diode (325, 345) fließenden Nebenschlußstroms (I₁).

## Revendications

1. Circuit écrêteur pour un circuit à transistor de puissance (32, 34, 36, 38) portant un transistor de puissance (321, 341) comprenant :
un premier circuit écrêteur adapté pour absorber une impulsion de tension à haut dv/dt, connecté en parallèle à un circuit collecteur-émetteur dudit transistor de puissance (321, 341) et comprenant un condensateur (324, 344) et une première diode (325, 345) ; et
un second circuit écrêteur, adapté pour absorber une énergie d'impulsion engendrée par une self induction de circuit, au moment de la mise à l'état non conducteur dudit transistor de puissance (321, 341), comprenant une seconde diode (327, 347) connectée audit condensateur (324, 344) et connectée en parallèle avec une résistance de décharge (326, 346), dans lequel ladite seconde diode (327, 347) dudit second circuit écrêteur est connectée à une jonction entre ledit condensateur (324, 344) et ladite première diode (325, 345), de sorte que le courant qui traverse ledit condensateur (324, 344) est divisé en un premier courant dérivé (I₁) qui traverse ladite première diode (325, 345) et un second courant dérivé (I₂) qui traverse ladite seconde diode, caractérisé en ce que lesdits premier et second circuits écrêteurs entrent en action pour réduire lesdits premier et second courants dérivés (I₁, I₂) qui traversent lesdites première et seconde diodes en fonction de l'accroissement de la tension dans ledit condensateur (324, 344), et ledit second circuit écrêteur a une plus grande inductance, en série avec la seconde diode, que ledit premier circuit écrêteur, de sorte que lesdits premier et second circuits écrêteurs font tomber à zéro lesdits premier et second courants dérivés à des instants différents l'un de l'autre, grâce au fait que le second circuit écrêteur maintient ledit second courant dérivé (I₂) après la fin du passage dudit premier courant dérivé (I₁) à travers ladite première diode (325, 345).

2. Circuit à transistor de puissance, comprenant :
un transistor de puissance (321, 341) connecté à une source de puissance et pouvant commuter entre un premier état pour établir un circuit collecteur-émetteur, et un second état, pour bloquer ledit circuit collecteur-émetteur pour transmettre une puissance d'alimentation à une charge (10) qui y est connectée ; et
un circuit écrêteur destiné à absorber une impulsion d'énergie engendrée lors de la commutation dudit transistor de puissance (321, 341) dudit premier état audit second état, le circuit écrêteur comprenant :
un premier circuit écrêteur, connecté en parallèle avec ledit circuit collecteur-émetteur dudit transistor de puissance (321, 341) et comprenant un condensateur (324, 344) et une première diode (325, 345) ; et
un second circuit écrêteur comprenant une seconde diode (327, 347) connectée audit condensateur (324, 344) et connectée en parallèle avec une résistance de décharge (326, 346) ;
dans lequel ledit premier circuit écrêteur est adapté pour absorber une impulsion de tension à haut dv/dt, et ledit second circuit écrêteur est adapté pour absorber une énergie d'impulsion engendrée par une self induction de circuit, au moment de la commutation dudit transistor de puissance (321, 341) dudit premier état audit second état, et dans lequel ladite seconde diode (327, 347) dudit second circuit écrêteur est connectée à une jonction entre ledit condensateur (324, 344) et ladite première diode (325, 345), de sorte que le courant (I_{cc}) qui traverse ledit condensateur (324, 344) est divisé en un premier courant dérivé (I₁) qui traverse ladite première diode (325, 345) et un second courant dérivé (I₂) qui traverse ladite seconde diode (327, 347), caractérisé en ce que lesdits premier et second circuits écrêteurs entrent en action pour réduire lesdits premier et second courants dérivés (I₁, I₂) qui traversent lesdites première et seconde diodes en fonction de l'accroissement de la tension de charge dans ledit condensateur (324, 344) et ledit second circuit écrêteur est doté d'une plus grande inductance, en série avec la seconde diode (327, 347), que ledit premier circuit écrêteur, de sorte que lesdits premier et second circuits écrêteurs font tomber à zéro lesdits premier et second courants dérivés à des instants différents l'un de l'autre, par le fait que le second circuit écrêteur maintient ledit second courant dérivé (I₂) après la fin du passage dudit premier courant dérivé (I₁) à travers ladite première diode (325, 345).

3. Circuit à transistor de puissance selon la revendication 2, qui comprend en outre un condensateur auxiliaire (Co) connecté en parallèle avec ladite première diode (325, 345).

4. Circuit à transistor de puissance selon la revendication 3, dans lequel ledit condensateur auxiliaire (Co) a une plus faible capacité que ledit condensateur (324, 344) inclus dans ledit premier circuit écrêteur.

5. Circuit à transistor de puissance selon une quelconque des revendications 2 à 4, dans lequel lesdits premier et second circuits écrêteurs sont montés sur une carte de circuit imprimé (40) connectée aux bornes d'électrode de collecteur et d'émetteur dudit transistor de puissance (321, 341) formé sur un substrat par des vis de connexion, et dans lequel ladite carte de circuit imprimé (40) est placée en un point espacé de la surface opposée du substrat.

6. Circuit onduleur connecté à une source de courant continu à travers un circuit filtre (20) comprenant un condensateur filtre (22) qui comprend :
une pluralité de circuits à transistor de puissance (32, 34, 36, 38) connectés à une charge (10) pour fournir un courant alternatif à cette dernière, chacun desdits circuits à transistor de puissance (32, 34, 36, 38) comprenant un transistor de puissance (321, 341) qui commute entre un premier état, pour établir un circuit collecteur-émetteur, et un second état, pour bloquer ledit circuit collecteur-émetteur ; et
un circuit écrêteur destiné à absorber une impulsion d'énergie engendrée au moment de la commutation dudit transistor de puissance (321, 341) dudit premier état audit second état, ledit circuit écrêteur comprenant un premier circuit écrêteur adapté pour absorber une impulsion de tension à haut dv/dt, connecté en parallèle à un circuit collecteur-émetteur dudit transistor de puissance (321, 341) et comprenant un condensateur (324, 344) et une première diode (325, 345), et un second circuit écrêteur adapté pour absorber une énergie d'impulsion engendrée par une self induction de circuit, au moment de la commutation dudit transistor de puissance dudit premier état audit second état, comprenant une seconde diode (327, 347) connectée audit condensateur en parallèle avec une résistance de décharge (326, 346), dans lequel ladite seconde diode (327, 347) dudit second circuit écrêteur est connectée à une jonction entre ledit condensateur (324, 344) et ladite première diode (325, 345), de sorte que le courant qui traverse ledit condensateur (324, 344) est divisé en un premier courant dérivé (I₁) qui traverse ladite première diode (325, 345) et un second courant dérivé (I₂) qui traverse ladite seconde diode (327, 347), caractérisé en ce que lesdits premier et second circuits écrêteurs entrent en action pour réduire lesdits premier et second courants dérivés (I₁, I₂) qui traversent lesdites première et seconde diodes en fonction de l'accroissement de la tension de charge dans ledit condensateur (324, 344), et ledit second circuit écrêteur est doté d'une plus grande inductance, en série avec la seconde diode (327, 347), que ledit premier circuit écrêteur, de sorte que lesdits premier et second circuits écrêteurs font tomber à zéro lesdits premier et second courants dérivés à des instants différents l'un de l'autre, par le fait que le second circuit écrêteur maintient ledit second courant dérivé (I₂) après la fin du passage dudit premier courant dérivé (I₁) à travers ladite première diode (325, 345).
